# EUROPEAN PATENT APPLICATION

(11) **EP 4 207 519 A1**
(43) Date of publication of application: **05.07.2023**
(21) Application number: 21868737.4
(22) Date of filing: 18.09.2021
(51) Int. Cl.: H01S 5/20

(54) **LASER CHIP, TRANSMITTING OPTICAL SUB-ASSEMBLY, OPTICAL MODULE, AND LASER GENERATION DEVICE**

(30) Priority: 21.09.2020 CN 202010997500
(71) Applicant: Huawei Technologies Co., Ltd., Shenzhen, Guangdong 518129 (CN)
(72) Inventor: CHENG, Yuanbing, Shenzhen, Guangdong 518129 (CN); LING, Wei, Shenzhen, Guangdong 518129 (CN); MAO, Yuanfeng, Shenzhen, Guangdong 518129 (CN)
(74) Representative: Gill Jennings & Every LLP
(86) International application number: PCT/CN2021/119273
(87) International publication number: WO 2022/057915

(57) **Abstract**

A laser chip, a transmitter optical sub-assembly (201), an optical module, and a laser generation method are provided. The laser chip includes at least a first laser (301) and a second laser (302). The first laser (301) and the second laser (302) share a same substrate (303). A waveguide of the first laser (301) and a waveguide of the second laser (302) are connected in series in a light output direction of the laser chip. The first laser (301) and the second laser (302) are electrically isolated from each other. A grating period of a first grating (304) of the first laser (301) is different from a grating period of a second grating (305) of the second laser (302). The first grating (304) is configured to perform mode selection on light generated by the first laser (301), to obtain first output light. The second grating (305) is configured to perform mode selection on light generated by the second laser (302), to obtain second output light. Since the laser chip may output light with different wavelengths, the transmitter optical sub-assembly (201) obtained by packaging the laser chip can implement multi-wavelength transmission. This achieves an effect achievable only by a plurality of groups of transmitter optical sub-assemblies (201). In this way, an overall structure of an optical module using the transmitter optical sub-assembly (201) is simpler.

## Description

This application claims priority to Chinese Patent Application No. 202010997500.2, filed with the China National Intellectual Property Administration on September 21, 2020 and entitled "LASER CHIP, TRANSMITTER OPTICAL SUB-ASSEMBLY, OPTICAL MODULE, AND LASER GENERATION METHOD", which is incorporated herein by reference in its entirety.

### TECHNICAL FIELD

This application relates to the field of optical communication, and in particular, to a laser chip, a transmitter optical sub-assembly, an optical module, and a laser generation method.

### BACKGROUND

Currently, a passive optical network (passive optical network, PON) deployed in a large scale includes a gigabit passive optical network (Gigabit passive optical network, GPON). With upgrading of network bandwidth, a 10G-GPON further needs to be deployed subsequently. To resolve a problem in coexistence of the GPON and the 10G-GPON, a GPON optical module and a 10G-GPON optical module may be combined into a combo (combo) optical module.

In an existing design manner of the combo optical module, two groups of transmitter optical sub-assemblies (transmitter optical sub-assemblies, TOSAs) and receiver optical sub-assemblies (receiver optical sub-assemblies, ROSAs) are disposed in a same package structure. In addition, a series of wavelength division multiplexing (wavelength division multiplexing, WDM) apparatuses are disposed in the package structure to implement transceiver functions of the GPON and transceiver functions of the 10G-GPON.

However, in this design manner, two groups of TOSAs and ROSAs are used, and a large quantity of WDM apparatuses are required in the package structure. As a result, a structure of the combo optical module is complex.

### SUMMARY

Embodiments of this application provide a laser chip, a transmitter optical sub-assembly, an optical module, and a laser generation method.

According to a first aspect, an embodiment of this application provides a laser chip, including at least a first laser and a second laser. The first laser and the second laser share a same substrate. A waveguide of the first laser and a waveguide of the second laser are connected in series in a light output direction of the laser chip. The first laser and the second laser are electrically isolated from each other. The first laser includes a first grating, and the second laser includes a second grating. A grating period of the first grating is different from a grating period of the second grating. Specifically, the first grating is configured to perform mode selection on light generated by the first laser, to obtain first output light with a first wavelength. The second grating is configured to perform mode selection on light generated by the second laser, to obtain second output light with a second wavelength.

In this implementation, a plurality of lasers are integrated into the laser chip, and multi-wavelength output can be implemented by using one laser chip. A plurality of lasers may share a same substrate and a same active region, and therefore a small quantity of types of materials are used, and a complex monolithic integration technology and circuit control do not need to be used. Waveguides of lasers in the laser chip are connected in series in the light output direction, and light coupling is simpler. Therefore, a TOSA obtained by packaging the laser chip can implement multi-wavelength transmission. This achieves an effect achievable only by a plurality of groups of TOSAs. In this way, an overall structure of an optical module using the TOSA is simpler.

In some possible implementations, the first laser and the second laser share a same laser facet. In this design manner, the light generated by the two lasers is not emitted from two different facets, and no combiner needs to be disposed, so that an overall structure of the laser chip is simpler.

In some possible implementations, the first laser and the second laser share a same active layer. To enable the output light of the two lasers to have good gain effects, the first wavelength and the second wavelength need to be located on two sides of a wavelength corresponding to a gain peak of the active layer.

In some possible implementations, the first laser uses a first active layer, and the second laser uses a second active layer. To enable the output light of the two lasers to have good gain effects, the first wavelength is aligned with a wavelength corresponding to a gain peak of the first active layer, and the second wavelength is aligned with a wavelength corresponding to a gain peak of the second active layer.

In some possible implementations, an output wavelength of the first laser is greater than an output wavelength of the second laser. A distance between the waveguide of the first laser and the laser facet is greater than a distance between the waveguide of the second laser and the laser facet. It can be understood that a photon with a short wavelength has large energy, and is more easily absorbed during transmission in a waveguide. To reduce absorption of the photon, a laser with a shorter output wavelength needs to be closer to the laser facet, so that performance of the laser chip is better.

In some possible implementations, the laser chip further includes an optical amplifier. The optical amplifier uses the same substrate. The first laser, the second laser, and the optical amplifier are electrically isolated from each other. Specifically, the optical amplifier is configured to perform optical amplification on the first output light and/or the second output light. It can be understood that, except that the optical amplifier does not include a grating, material structures of other layers are similar to those of the foregoing laser. Optical output power of the laser chip may be increased by disposing the optical amplifier. Preferably, to achieve an optimal optical amplification effect, the optical amplifier needs to be disposed at a position closest to the laser facet of the laser chip.

In some possible implementations, the laser chip further includes a controller, a first switch, a second switch, a first current source, and a second current source. One end of the first switch is connected to an electrode of the first laser, and the other end of the first switch is connected to the first current source. One end of the second switch is connected to an electrode of the second laser, and the other end of the second switch is connected to the second current source. Specifically, the controller is configured to load, onto the electrode of the first laser by controlling the first switch, a current output by the first current source; and/or the controller is configured to load, onto the electrode of the second laser by controlling the second switch, a current output by the second current source. In this embodiment, a specific implementation of outputting different wavelengths by a laser chip is provided, to increase practicability of this solution.

Notably, the controller may implement a plurality of working modes by controlling the first switch and the second switch. In a first working mode, a direct current or an alternating current signal greater than or equal to a threshold is loaded onto the first laser. No current is loaded onto the second laser. In this working mode, a loss of the output light of the first laser caused by the waveguide of the second laser is large, and output light power of the first laser is small. In a second working mode, a direct current or an alternating current signal greater than or equal to a threshold is loaded onto the first laser. A direct current less than the threshold is loaded onto the second laser. In this working mode, a loss of the output light of the first laser caused by the waveguide of the second laser is close to 0, the second laser may amplify the output light of the first laser, and output light power of the first laser is moderate. In a third working mode, a direct current or an alternating current signal greater than or equal to a threshold is loaded onto the first laser. A direct current greater than or equal to the threshold is loaded onto the second laser. In this working mode, the second laser may also amplify the output light of the first laser. However, the second laser also outputs light, and thus a supplementary component needs to filter the light, to ensure outputting of a single wavelength. By comparing the foregoing three working modes, it may be learned that the second working mode has an optimal effect.

In some possible implementations, a groove is provided between the first laser and the second laser. The groove may increase an isolation resistance between the electrodes of the two lasers, to implement electrical isolation between the first laser and the second laser.

In some possible implementations, a proton or an inert ion may be further injected into the groove to increase an electrical isolation effect.

In some possible implementations, a proton or an inert ion may be injected between the electrode of the first laser and the electrode of the second laser, to implement electrical isolation between the first laser and the second laser. This increases flexibility of this solution. It can be understood that, to make an overall structure of the laser chip in this application more compact and be less interfered, a distance between the electrode of the first laser and the electrode of the second laser needs to be in a preset distance range. For example, the distance between the electrode of the first laser and the electrode of the second laser is greater than or equal to 5 µm and less than or equal to 200 µm.

In some possible implementations, the first wavelength is 1310 nm, and the second wavelength is 1270 nm; the first wavelength is 1577 nm, and the second wavelength is 1490 nm; or the first wavelength is 1342 nm, and the second wavelength is 1310 nm or 1270 nm. The laser in this application may be compatible with a plurality of PON networks, for example, a GPON and an XGPON, so that scalability of this solution is increased.

In some possible implementations, the substrate may be a silicon-based semiconductor material, indium phosphide (InP), or the like.

According to a second aspect, an embodiment of this application provides a laser generation method. The method includes the following steps. First, an output wavelength is determined. Since wavelengths of output light of lasers in a laser chip are different, a laser in the laser chip, for example, a first laser, can be determined based on a wavelength that needs to be output. Next, a first current is loaded, by using a first current source, onto the first laser that is in the laser chip and that corresponds to the output wavelength. In this way, the first laser generates an optical signal with the output wavelength. It can be understood that the first current is greater than or equal to a current threshold of the first laser. Then, the optical signal generated by the first laser is output.

In some possible implementations, a second current may be loaded onto a second laser in the laser chip by using a second current source, to amplify the optical signal generated by the first laser. The second current is less than a current threshold of the second laser. The second laser is only configured to amplify the optical signal generated by the first laser. The second laser does not generate an optical signal, and external filtering is not required.

In some possible implementations, a third current may be loaded onto a second laser in the laser chip by using a second current source, to output a second optical signal generated by the second laser. The third current is greater than or equal to a current threshold of the second laser. In this embodiment, in addition to amplifying the optical signal generated by the first laser, the second laser also generates an optical signal.

According to a third aspect, an embodiment of this application provides a transmitter optical sub-assembly (Transmitter Optical sub-assembly, TOSA), including the laser chip according to the first aspect, a monitor photodiode (monitor photodiode, MPD), and a package structure. The package structure includes a header, a transistor cap, and a lens. The laser chip and the MPD are disposed on the header. The MPD is configured to monitor optical power output by the laser chip. The transistor cap is sleeved on the header. The lens is disposed on the transistor cap. The lens is configured to aggregate light emitted by the laser chip.

According to a fourth aspect, an embodiment of this application provides an optical module, including the transmitter optical sub-assembly according to the third aspect, a housing, a receiver optical sub-assembly (Receiver Optical sub-assembly, ROSA), a wavelength division multiplexing (wavelength division multiplexing, WDM) filter, and an optical fiber connection port. The TOSA, the ROSA, and the optical fiber connection port are disposed on the housing. The WDM filter is disposed in the housing. Specifically, the WDM filter is configured to: transmit, to the optical fiber connection port, light emitted by the TOSA, and reflect light from the optical fiber connection port to the ROSA.

It can be learned from the foregoing technical solutions that embodiments of this application have the following advantages: A plurality of lasers are integrated into the laser chip provided in this application. Multi-wavelength output can be implemented by using one laser chip. A plurality of lasers may share a same substrate and a same active region, and therefore a small quantity of types of materials are used, and a complex monolithic integration technology and circuit control do not need to be used. Waveguides of lasers in the laser chip are connected in series in a light output direction, and light coupling is simpler. Therefore, a TOSA obtained by packaging the laser chip can implement multi-wavelength transmission. This achieves an effect achievable only by a plurality of groups of TOSAs. In this way, an overall structure of an optical module using the TOSA is simpler.

### BRIEF DESCRIPTION OF DRAWINGS

FIG. 1 is a schematic diagram of a structure of a PON system;
FIG. 2 is a schematic diagram of a structure of an optical module according to an embodiment of this application;
FIG. 3 is a schematic diagram of a first structure of a laser chip according to an embodiment of this application;
FIG. 4 is a schematic diagram of a second structure of a laser chip according to an embodiment of this application;
FIG. 5 is a schematic diagram of a third structure of a laser chip according to an embodiment of this application;
FIG. 6 is a schematic diagram of a fourth structure of a laser chip according to an embodiment of this application;
FIG. 7 is a schematic diagram of a gain spectrum of a laser according to an embodiment of this application;
FIG. 8 is a schematic diagram of a fifth structure of a laser chip according to an embodiment of this application;
FIG. 9 is a schematic diagram of another gain spectrum of a laser according to an embodiment of this application;
FIG. 10 is a schematic diagram of a sixth structure of a laser chip according to an embodiment of this application;
FIG. 11 is a schematic diagram of a seventh structure of a laser chip according to an embodiment of this application; and
FIG. 12 is a schematic diagram of an embodiment of a laser generation method according to an embodiment of this application.

### DESCRIPTION OF EMBODIMENTS

Embodiments of this application provide a laser chip, a transmitter optical sub-assembly, an optical module, and a laser generation method.

Notably, the terms "first", "second", "third", "fourth", and the like in the specification, claims, and accompanying drawings of this application are used to distinguish between similar objects, but do not limit a specific order or sequence. It can be understood that the foregoing terms are interchangeable in proper circumstances, so that embodiments described in this application can be implemented in other orders rather than the content described in this application. Moreover, the terms "include", "have", and any other variants thereof are intended to cover a non-exclusive inclusion. For example, processes, methods, systems, products, or devices that include a series of steps or units are not limited to the steps or the units that are clearly listed, and may include other steps and units that are not clearly listed or that are inherent to the processes, methods, products, or devices.

This application is mainly applied to a passive optical network (passive optical network, PON) system. The following first describes the PON system.

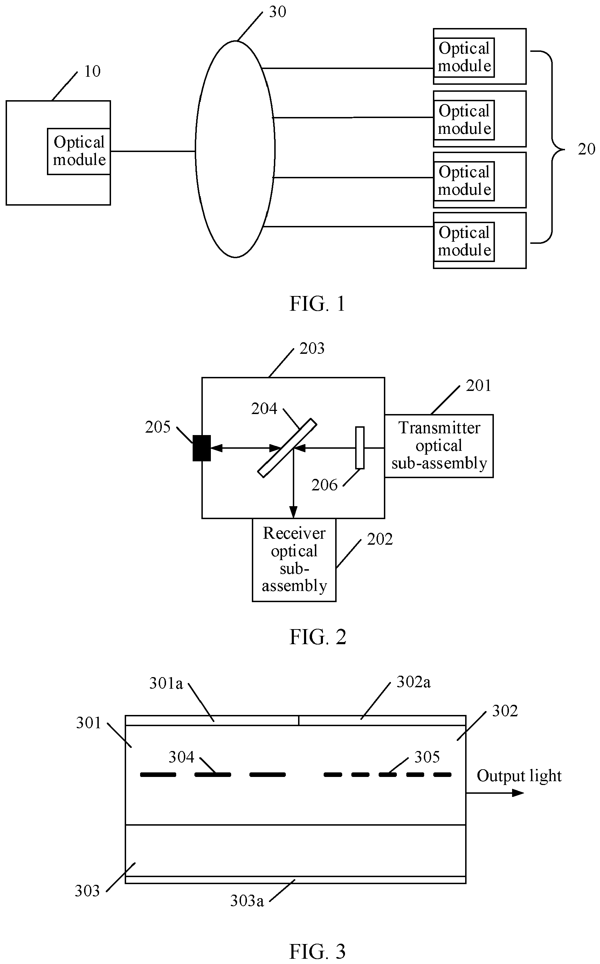

FIG. 1 is a schematic diagram of a structure of a PON system. A network device in the PON system includes an optical line terminal (optical line terminal, OLT) 10 and an optical network unit (Optical Network Unit, ONU) 20. An optical distribution network (Optical distribution network, ODN) 30 is deployed between the optical line terminal 10 and the optical network unit 20. An optical module is disposed in each of the optical line terminal 10 and the optical network unit 20. The following describes an optical module provided in this application with reference to the accompanying drawings.

FIG. 2 is a schematic diagram of a structure of an optical module according to an embodiment of this application. The optical module includes a transmitter optical sub-assembly (Transmitter Optical sub-assembly, TOSA) 201 and a receiver optical sub-assembly (Receiver Optical sub-assembly, ROSA) 202. The transmitter optical sub-assembly 201 and the receiver optical sub-assembly 202 are packaged on a housing 203. A wavelength division multiplexing (wavelength division multiplexing, WDM) filter 204 is further disposed in the housing 203. A port 205 on the housing 203 is used to connect to an optical fiber. Specifically, light emitted by the transmitter optical sub-assembly 201 is transmitted by the WDM filter 204 and is output from the port 205. Light input from the port 205 is reflected and transmitted to the receiver optical sub-assembly 202 by the WDM filter 204.

Notably, the optical module provided in this application may implement multi-wavelength receiving and sending. For example, an OLT in a GPON uses a wavelength of 1490 nm for sending and a wavelength of 1310 nm for receiving. An OLT in an XGPON uses a wavelength of 1577 nm for sending and a wavelength of 1270 nm for receiving. The transmitter optical sub-assembly 201 may support transmitting light with the wavelength of 1490 nm and light with the wavelength of 1577 nm. The receiver optical sub-assembly 202 may support receiving light with the wavelength of 1310 nm and light with the wavelength of 1270 nm. Optionally, to filter out scattering light, a band-pass filter may be further disposed on an optical path in which the transmitter optical sub-assembly 201 transmits light.

It can be understood that, that one TOSA can output a plurality of pieces of light with different wavelengths is mainly implemented in this application. A quantity of ROSAs used in the optical module is not limited in this application. As shown in FIG. 2, multi-wavelength receiving may be implemented by using one ROSA. Alternatively, light with different wavelengths may be respectively received by using a plurality of ROSAs. This is not described in this application with reference to the accompanying drawings. The following describes the TOSA provided in this application.

The TOSA is usually packaged in a form of a transistor-outline can (transistor-outline can, TO-CAN). The TOSA includes a laser chip, a monitor photodiode (monitor photodiode, MPD), and a package structure. The package structure includes a header, a transistor cap, and a lens. The laser chip and the MPD are disposed on the header. The MPD is configured to monitor optical power output by the laser chip. The transistor cap is sleeved on the header. The lens is disposed on the transistor cap. The lens is configured to aggregate light emitted by the laser chip. It can be understood that a carrier, a sleeve, an optical fiber ferrule with an optical cable pigtail, an optical fiber adapter, and the like may be further disposed outside the package structure of the TOSA. The carrier is configured to fasten the package structure. The sleeve is configured to connect the carrier and the optical fiber adapter. The optical fiber adapter is configured to connect to the optical fiber ferrule with an optical cable pigtail. Notably, the TOSA in this application may alternatively use another package manner such as box-shaped packaging. This is not specifically limited herein.

According to the foregoing descriptions, the optical module provided in this application can implement multi-wavelength transmission by disposing only one TOSA. There is no need to manufacture a plurality of groups of TOSAs, and there is no need to use a large quantity of WDM filters and coupling lenses. In this way, an overall structure of the optical module is simpler. It can be understood that the laser chip used in the TOSA in this application may transmit a plurality of pieces of light with different wavelengths. The following describes the laser chip provided in this application in detail.

FIG. 3 is a schematic diagram of a first structure of a laser chip according to an embodiment of this application. The laser chip includes at least a first laser 301 and a second laser 302. The first laser 301 and the second laser 302 use a same substrate 303. A waveguide of the first laser 301 and a waveguide of the second laser 302 are connected in series in a light output direction of the laser chip and are connected to a laser facet of the laser chip. In addition, the first laser 301 and the second laser 302 are electrically isolated from each other. It can be understood that both the first laser 301 and the second laser 302 are manufactured based on the substrate 303. The first laser 301 is not limited to a part growing on the substrate 303. The substrate 303 is also a component of the first laser 301. Similarly, the second laser 302 is not limited to a part growing on the substrate 303. The substrate 303 is also a component of the first laser 302. To be specific, the first laser 301, the second laser 302, and the substrate 303 form a monolithic integration structure.

It can be understood that, to obtain large output power, a laser usually uses a long laser resonant cavity, so that output of the laser is multi-mode. Therefore, to increase coherence of output light, the laser needs to operate in a single longitudinal mode, to be specific, output light with a single wavelength. In this application, mode selection is performed by using a grating disposed in the laser, so that the laser outputs the light with a single wavelength. Specifically, the first laser 301 includes a first grating 304. The second laser 302 includes a second grating 305. A grating period of the first grating 304 is different from a grating period of the second grating 305. The first grating 304 is configured to perform mode selection on light generated by the first laser 301, to obtain first output light with a first wavelength. The second grating 305 is configured to perform mode selection on light generated by the second laser 302, to obtain second output light with a second wavelength.

A material structure, from bottom to top, of the laser chip includes the substrate 303, a lower separate confinement heterostructure layer, a multi-quantum well active layer, an upper separate confinement heterostructure layer, a grating layer, a spatial layer, a waveguide confinement heterostructure layer, and an electrode. Notably, the structure of the layers listed above is a conventional structure of a laser, and the layers are not marked one by one in the accompanying drawings herein. The upper separate confinement heterostructure layer and the lower separate confinement heterostructure layer are used to limit carriers and photons in a vertical direction. The first grating 304 and the second grating 305 are disposed in the grating layer. The spatial layer is mainly used to facilitate grating manufacturing, and is an etching stop layer of the grating layer. The waveguide confinement heterostructure layer above the spatial layer is used to form a waveguide for optical transmission.

It can be understood that the first laser 301 and the second laser 302 share a same laser facet. To enable the light generated by the first laser 301 and the second laser 302 to be transmitted in a direction of the laser facet, a high reflection (High Reflection, HR) film needs to be coated on a facet opposite to the laser facet. In addition, an anti-reflection (Anti-Reflection, AR) film may be coated on the laser facet to increase light output power. In this design manner, the light generated by the two lasers is not emitted from two different facets, and no combiner needs to be disposed, so that an overall structure of the laser chip is simpler.

Notably, arrangement positions of the first laser 301 and the second laser 302 may be determined by respective output wavelengths. Since a photon with a short wavelength has large energy, the photon is more easily absorbed during transmission in a waveguide. To reduce absorption of the photon, in other words, to increase output light power, a laser with a shorter output wavelength needs to be closer to the laser facet. As shown in FIG. 3, the second laser 302 is closer to the laser facet than the first laser 301 is. In other words, the first wavelength of the output light of the first laser 301 is greater than the second wavelength of the output light of the second laser 302. The grating period of the first grating 304 is greater than the grating period of the second grating 305.

Notably, that a wavelength of output light of each laser in the laser chip is not limited in this application. For example, the wavelength of the output light of the first laser 301 is 1310 nm, and the wavelength of the output light of the second laser 302 is 1270 nm. For another example, the wavelength of the output light of the first laser 301 is 1577 nm, and the wavelength of the output light of the second laser 302 is 1490 nm. For still another example, the wavelength of the output light of the first laser 301 is 1342 nm, and the wavelength of the output light of the second laser 302 is 1310 nm or 1270 nm. In addition, the substrate of the laser chip in this application may be a silicon-based semiconductor material, indium phosphide (InP), or the like. This is not specifically limited herein.

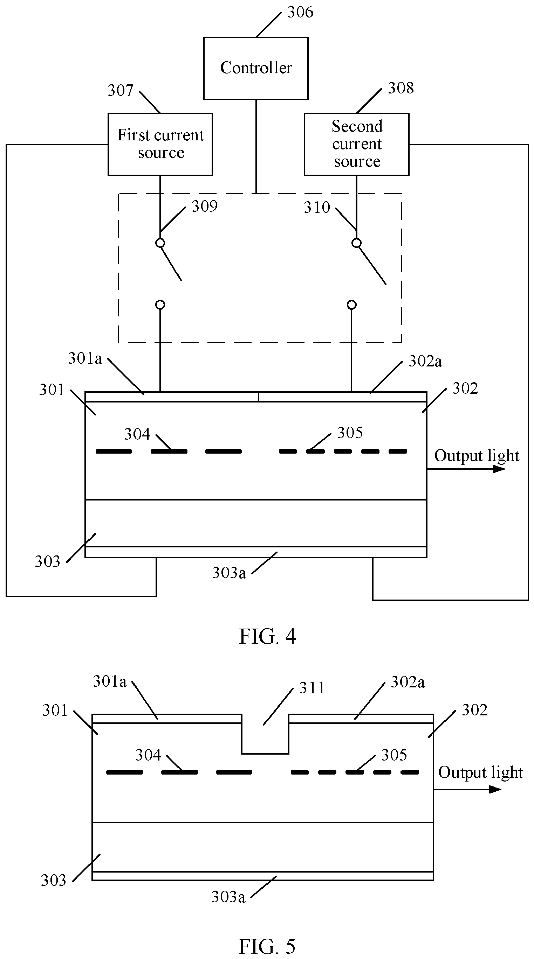

FIG. 4 is a schematic diagram of a second structure of a laser chip according to an embodiment of this application. In a possible implementation, a P-type electrode 301a is disposed on an upper surface of the first laser 301. A P-type electrode 302a is disposed on an upper surface of the second laser 302. An N-type electrode 303a is disposed on a lower surface of the substrate 303. A controller 306, a first current source 307, a second current source 308, a first switch 309, and a second switch 310 may be further disposed on a periphery of the first laser 301 and the second laser 302. One end of the first switch 309 is connected to the P-type electrode 301a of the first laser 301, and the other end of the first switch 309 is connected to the first current source 307. One end of the second switch 310 is connected to the P-type electrode 302a of the second laser 302, and the other end of the second switch 310 is connected to the second current source 308. The controller 306 is configured to control the first switch 309 and the second switch 310 to be turned on or off. Specifically, the controller 306 loads, onto the P-type electrode 301a of the first laser 301 and the N-type electrode 303a by controlling the first switch 309, a current output by the first current source 307. The controller 306 loads, onto the P-type electrode 302a of the second laser 302 and the N-type electrode 303a by controlling the second switch 310, a current output by the second current source 308. It can be understood that a laser can generate laser light only when a current loaded onto the laser is greater than or equal to a current threshold of the laser. Current thresholds of the first laser and the second laser are not limited in this application.

Optionally, the first laser 301 and the second laser 302 may generate continuous light, or may generate optical signals. For example, if a direct current is loaded onto the first laser 301, the first laser 301 generates continuous light. If an alternating current signal is loaded onto the first laser 301, the first laser 301 generates an optical signal.

Notably, the controller 306 may implement a plurality of different working modes by controlling the first switch 309 and the second switch 310. The following describes several working modes of the laser chip in this application.

In a first working mode, a direct current or an alternating current signal greater than or equal to a threshold is loaded onto the first laser 301. No current is loaded onto the second laser 302. In this case, the laser chip outputs the first output light with the first wavelength. In this working mode, a loss of the first output light caused by the waveguide of the second laser 302 is large, and power of the first output light is small.

In a second working mode, a direct current or an alternating current signal greater than or equal to a threshold is loaded onto the first laser 301. A direct current less than the threshold is loaded onto the second laser 302. In this case, the laser chip outputs the first output light with the first wavelength. In this working mode, a loss of the first output light caused by the waveguide of the second laser 302 is close to 0, the second laser 302 may amplify the first output light, and power of the first output light is moderate.

In a third working mode, a direct current or an alternating current signal greater than or equal to a threshold is loaded onto the first laser 301. A direct current greater than or equal to the threshold is loaded onto the second laser 302. In this case, the laser chip outputs the first output light with the first wavelength and the second output light with the second wavelength. In this working mode, the second laser 302 may further amplify the first output light. Power of the first output light is large, but the second output light needs to be filtered by using an external component (for example, a filter).

In a fourth working mode, a direct current or an alternating current signal greater than or equal to a threshold is loaded onto the second laser 302. No current is loaded onto the first laser 301. In this case, the laser chip outputs the second output light with the second wavelength, and power of the second output light is small.

In a fifth working mode, a direct current or an alternating current signal greater than or equal to a threshold is loaded onto the second laser 302. A direct current less than the threshold is loaded onto the first laser 301. In this case, the laser chip outputs the second output light with the second wavelength, and power of the second output light is moderate.

In a sixth working mode, a direct current or an alternating current signal greater than or equal to a threshold is loaded onto the second laser 302. A direct current greater than or equal to the threshold is loaded onto the first laser 301. In this case, the laser chip outputs the first output light with the first wavelength and the second output light with the second wavelength, and power of the second output light is large.

In this embodiment, electrical isolation between the first laser 301 and the second laser 302 may be implemented in a plurality of manners. The following separately describes the manners.

In a first manner, a proton or an inert ion is injected between the P-type electrodes of the first laser 301 and the second laser 302, to implement electrical isolation between the first laser 301 and the second laser 302. The inert ion may be an ion such as helium, neon, or argon. It can be understood that, to make an overall structure of the laser chip in this application more compact and be less interfered, a distance between the electrode of the first laser and the electrode of the second laser needs to be in a preset distance range. For example, the distance between the electrode of the first laser and the electrode of the second laser is greater than or equal to 5 µm and less than or equal to 200 µm.

In a second manner, FIG. 5 is a schematic diagram of a third structure of a laser chip according to an embodiment of this application. As shown in FIG. 5, a groove 311 is provided between the first laser 301 and the second laser 302. The groove 311 may increase an isolation resistance between the electrodes of the two lasers, to implement electrical isolation between the first laser 301 and the second laser 302. It can be understood that, provided that electrical isolation between the first laser 301 and the second laser 302 can be implemented without affecting normal operation of the first laser 301 and the second laser 302, a depth of the groove is not limited in this application. Optionally, to improve an electrical isolation effect, a proton or an inert ion may be further injected into the groove.

Notably, the first laser 301 and the second laser 302 may share a same active layer, or may use different active layers. The following separately provides descriptions.

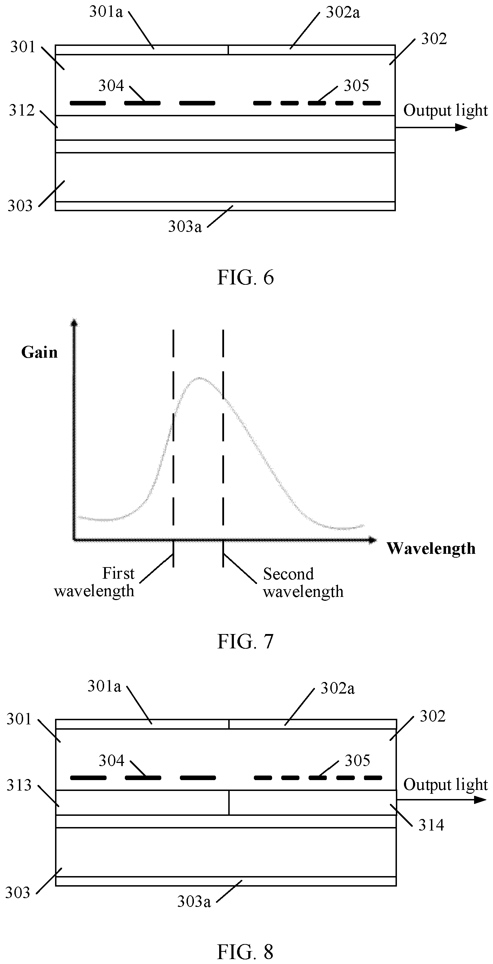

FIG. 6 is a schematic diagram of a fourth structure of a laser chip according to an embodiment of this application. As shown in FIG. 6, the first laser 301 and the second laser 302 share an active layer 312. To enable the output light of the two lasers to have good gain effects, the following design manner may be used for implementation. FIG. 7 is a schematic diagram of a gain spectrum of a laser according to an embodiment of this application. A horizontal coordinate represents a wavelength, and a vertical coordinate represents a gain. The first wavelength and the second wavelength need to be located on two sides of a wavelength corresponding to a gain peak of the active layer.

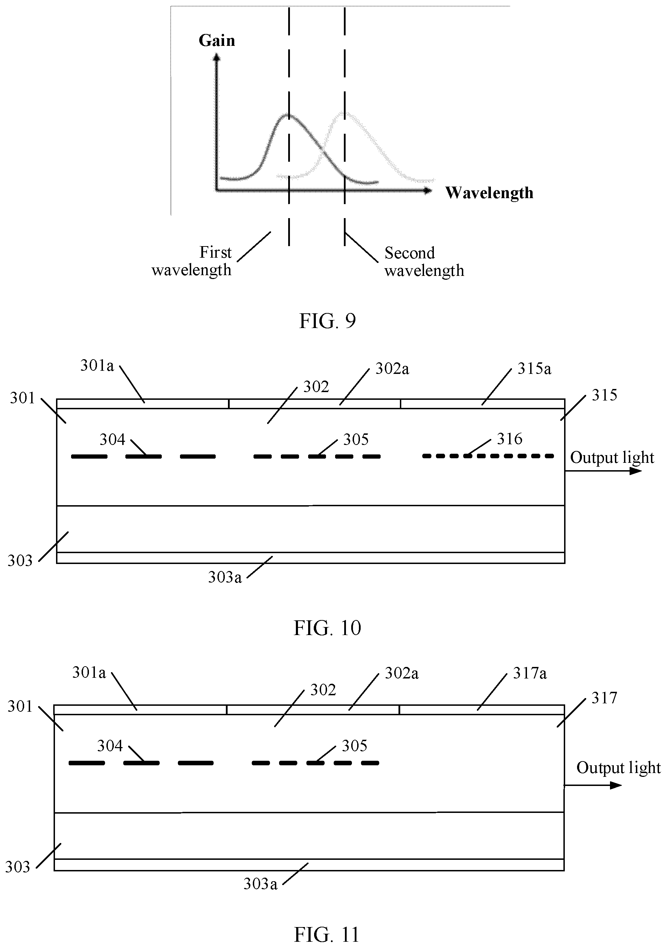

FIG. 8 is a schematic diagram of a fifth structure of a laser chip according to an embodiment of this application. As shown in FIG. 8, the first laser 301 uses a first active layer 313, and the second laser uses a second active layer 314. To enable the output light of the two lasers to have good gain effects, the following design manner may be used for implementation. FIG. 9 is a schematic diagram of another gain spectrum of a laser according to an embodiment of this application. A horizontal coordinate represents a wavelength, and a vertical coordinate represents a gain. The first wavelength is aligned with a wavelength corresponding to a gain peak of the first active layer. The second wavelength is aligned with a wavelength corresponding to a gain peak of the second active layer.

Notably, lasers included in the laser chip provided in this application are not limited to the first laser and the second laser in the examples. The following provides descriptions with reference to a specific example.

FIG. 10 is a schematic diagram of a sixth structure of a laser chip according to an embodiment of this application. As shown in FIG. 10, the laser chip may further include a third laser 315. A P-type electrode 315a is disposed on an upper surface of the third laser 315. The third laser 315 also uses the substrate 303. The third laser 315 and the second laser 302 are electrically isolated from each other. In addition, waveguides of the three lasers are connected in series in a light output direction of the laser chip. The third laser 315 includes a third grating 316. A grating period of the third grating 316 is also different from the grating period of the first grating 304 and the grating period of the second grating 305. Specifically, the third grating 316 performs mode selection on light generated by the third laser 313, to obtain third output light with a third wavelength. It can be understood that an implementation of controlling the third laser 315 to generate laser light is similar to the manner described in FIG. 4. Details are not described herein again. Preferably, to reduce absorption of a photon, the third laser 315 with a shortest output wavelength is closest to the laser facet. To be specific, the first wavelength is greater than the second wavelength, and the second wavelength is greater than the third wavelength. The grating period of the first grating 304 is greater than the grating period of the second grating 305, and the grating period of the second grating 305 is greater than the grating period of the third grating 314.

In a possible implementation, the laser chip provided in this application may further include an optical amplifier. The following provides descriptions with reference to a specific example.

FIG. 11 is a schematic diagram of a seventh structure of a laser chip according to an embodiment of this application. As shown in FIG. 11, the laser chip may further include an optical amplifier 317. The optical amplifier 317 also uses the substrate 303. The optical amplifier 317 and the second laser 302 are electrically isolated from each other. Specifically, a current may be injected into an electrode 317a of the optical amplifier 317, to amplify the light output by the first laser 301 and/or the second laser 302. It can be understood that, except that the optical amplifier 317 does not include a grating, material structures of other layers are similar to those of the foregoing laser. Details are not described herein again. Notably, a specific position of the optical amplifier 317 is not limited in this application. For example, the optical amplifier 317 may be disposed, as shown in FIG. 11, on a right side of the second laser 203. For another example, the optical amplifier 317 may be disposed on a left side of the first laser 301. For still another example, the optical amplifier 317 may be disposed between the first laser 301 and the second laser 302. Preferably, to achieve an optimal optical amplification effect, the optical amplifier 317 needs to be disposed, as shown in FIG. 11, at a position closest to the laser facet of the laser chip.

A plurality of lasers are integrated into the laser chip provided in this application. Multi-wavelength output can be implemented by using one laser chip. The plurality of lasers may share a same substrate and a same active region, and therefore a small quantity of types of materials are used, and a complex monolithic integration technology and circuit control do not need to be used. Waveguides of lasers in the laser chip are connected in series in a light output direction, and light coupling is simpler. Therefore, a TOSA obtained by packaging the laser chip can implement multi-wavelength transmission. This achieves an effect achievable only by a plurality of groups of TOSAs. In this way, an overall structure of an optical module using the TOSA is simpler.

Based on the foregoing descriptions of the laser chip, the following describes a laser generation method with reference to the laser chip. Notably, an apparatus structure corresponding to the laser generation method may be described in the descriptions in the foregoing apparatus embodiment. However, the apparatus structure is not limited to the foregoing laser chip.

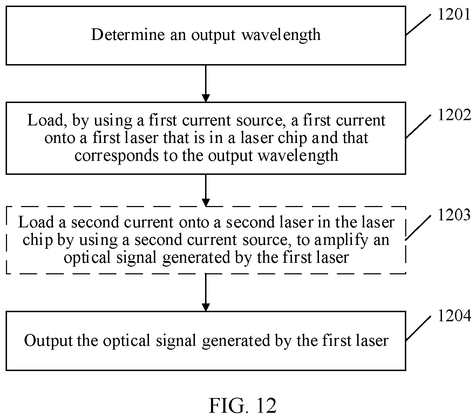

FIG. 12 is a schematic diagram of an embodiment of a laser generation method according to an embodiment of this application. In this example, the laser generation method includes the following steps.

1201: Determine an output wavelength.

In this embodiment, a laser chip includes a plurality of lasers, where the plurality of lasers share a same substrate and are electrically isolated from each other. Waveguides of the plurality of lasers are connected in series in a light output direction of the laser chip. Since grating periods of gratings used by the lasers are different, wavelengths of output light of the lasers are different. Therefore, a laser in the laser chip may be determined based on a wavelength that needs to be output. The following uses a selected first laser as an example for specific description.

It can be understood that for a specific structure of the laser chip, refer to the related descriptions in the foregoing apparatus embodiment, and details are not described herein again.

1202: Load, by using a first current source, first current onto a first laser that is in the laser chip and that corresponds to the output wavelength.

Since an output wavelength of the first laser is consistent with the wavelength that needs to be output, the first current may be loaded onto the first laser by using the first current source, so that the first laser works. FIG. 4 is used as an example. The controller 306 controls the first switch 309 to be turned on, so that a current output by the first current source 307 is loaded onto the first laser 301. The first laser 301 is to generate a first optical signal. It can be understood that, to generate laser light, the current loaded onto the first laser 301 needs to be greater than or equal to a current threshold of the first laser 301.

Optionally, in a possible implementation, the laser generation method further includes step 1203.

1203: Load a second current onto a second laser in the laser chip by using a second current source, to amplify the optical signal generated by the first laser.

FIG. 4 is used as an example. The controller 306 may further control the second switch 310 to be turned on, so that a current output by the second current source 308 is loaded onto the second laser 302. If the current output by the second current source 308 is less than a current threshold of the second laser 302, the second laser 302 is only configured to amplify the first optical signal generated by the first laser, and does not generate an optical signal. If the current output by the second current source 308 is greater than or equal to a current threshold of the second laser 302, the second laser 302 not only amplifies the first optical signal generated by the first laser, but also generates a second optical signal. It can be understood that the laser chip provided in this application has a plurality of working modes. For details, refer to the related descriptions in the foregoing apparatus embodiment. Details are not described herein again.

Optionally, in another possible implementation, the laser chip in this application may further include an optical amplifier, for example, as shown in FIG. 11. In this case, the light that needs to be output may be amplified by loading a current onto the optical amplifier. Details are not described herein again.

1204: Output the optical signal generated by the first laser.

Notably, the foregoing embodiments are merely used to describe the technical solutions of this application, but are not intended to limit this application. Although this application is described in detail with reference to the foregoing embodiments, persons of ordinary skill in the art can understand that they may still make modifications to the technical solutions described in the foregoing embodiments or make equivalent replacements to some technical features thereof, without departing from the spirit and scope of the technical solutions of the embodiments of this application.

## Claims

1. A laser chip, wherein the laser chip comprises at least a first laser and a second laser, wherein
the first laser and the second laser share a same substrate, a waveguide of the first laser and a waveguide of the second laser are connected in series in a light output direction of the laser chip, the first laser and the second laser are electrically isolated from each other, the first laser comprises a first grating, the second laser comprises a second grating, and a grating period of the first grating is different from a grating period of the second grating;
the first grating is configured to perform mode selection on light generated by the first laser, to obtain first output light with a first wavelength; and
the second grating is configured to perform mode selection on light generated by the second laser, to obtain second output light with a second wavelength.

2. The laser chip according to claim 1, wherein the first laser and the second laser share a same laser facet.

3. The laser chip according to claim 1 or 2, wherein the first laser and the second laser share a same active layer, the first wavelength is less than a wavelength corresponding to a gain peak of the active layer, and the second wavelength is greater than the wavelength corresponding to the gain peak of the active layer.

4. The laser chip according to any one of claims 1 to 3, wherein the first wavelength is greater than the second wavelength, and a distance between the waveguide of the first laser and the laser facet is greater than a distance between the waveguide of the second laser and the laser facet.

5. The laser chip according to any one of claims 1 to 4, wherein the laser chip further comprises an optical amplifier, wherein the optical amplifier uses the substrate, and the first laser, the second laser, and the optical amplifier are electrically isolated from each other; and
the optical amplifier is configured to perform optical amplification on the first output light and/or the second output light.

6. The laser chip according to any one of claims 1 to 5, wherein the laser chip further comprises a controller, a first switch, a second switch, a first current source, and a second current source, wherein one end of the first switch is connected to an electrode of the first laser, the other end of the first switch is connected to the first current source, one end of the second switch is connected to an electrode of the second laser, and the other end of the second switch is connected to the second current source; and
the controller is configured to load, onto the electrode of the first laser by controlling the first switch, a current output by the first current source; and/or
the controller is configured to load, onto the electrode of the second laser by controlling the second switch, a current output by the second current source.

7. The laser chip according to any one of claims 1 to 6, wherein a groove is provided between the first laser and the second laser to implement electrical isolation.

8. The laser chip according to claim 7, wherein a proton or an inert ion is injected into the groove.

9. The laser chip according to any one of claims 1 to 6, wherein a proton or an inert ion is injected between the electrode of the first laser and the electrode of the second laser.

10. The laser chip according to any one of claims 1 to 9, wherein the first wavelength is 1310 nm, and the second wavelength 1270 nm; the first wavelength is 1577 nm, and the second wavelength is 1490 nm; or the first wavelength is 1342 nm, and the second wavelength is 1310 nm or 1270 nm.

11. A laser generation method, comprising:
determining an output wavelength;
loading, by using a first current source, a first current onto a first laser that is in a laser chip and that corresponds to the output wavelength, wherein the laser chip comprises a plurality of lasers, waveguides of the plurality of lasers are connected in series in a light output direction of the laser chip, the plurality of lasers are electrically isolated from each other, output wavelengths of the plurality of lasers are different, and the first current is greater than or equal to a current threshold of the first laser; and
outputting a first optical signal generated by the first laser.

12. The method according to claim 11, wherein the method further comprises:
loading, by using a second current source, a second current onto a second laser in the laser chip, to amplify the first optical signal, wherein the second current is less than a current threshold of the second laser.

13. The method according to claim 11, wherein the method further comprises:
loading, by using a second current source, a third current onto a second laser in the laser chip, to output a second optical signal generated by the second laser, wherein the third current is greater than or equal to a current threshold of the second laser.

14. A transmitter optical sub-assembly TOSA, comprising the laser chip according to any one of claims 1 to 10, a monitor photodiode MPD, and a package structure, wherein the package structure comprises a header, a transistor cap, and a lens, the laser chip and the MPD are disposed on the header, the MPD is configured to monitor optical power output by the laser chip, the transistor cap is sleeved on the header, the lens is disposed on the transistor cap, and the lens is configured to aggregate light emitted by the laser chip.

15. An optical module, comprising the TOSA according to claim 14, a housing, a receiver optical sub-assembly ROSA, a wavelength division multiplexing WDM filter, and an optical fiber connection port, wherein the TOSA, the ROSA, and the optical fiber connection port are disposed on the housing, and the WDM filter is disposed in the housing; and
the WDM filter is configured to: transmit, to the optical fiber connection port, light emitted by the TOSA, and reflect light from the optical fiber connection port to the ROSA.
